# EUROPEAN PATENT SPECIFICATION

(11) **EP 1 139 492 B1**
(45) Date of publication and mention of the grant of the patent: **01.06.2005**
(21) Application number: 01107625.4
(22) Date of filing: 27.03.2001
(51) Int. Cl.: H01R 4/16, H01R 4/18, H01R 12/08

(54) **A method for connecting a terminal fitting and a flat conductor and a terminal connection apparatus**
Verfahren zum Verbinden eines eines flachen Verbinders mit einem Anschlusskontakt und Vorrichtung zum Verbinden mit einem Anschlusskontakt
Procédé de connexion d'un conducteur plat avec un organe de contact et appareil de connexion avec un organe de contact

(30) Priority: 28.03.2000 JP 2000088119
(43) Date of publication of application: 04.10.2001
(73) Proprietor: Sumitomo Wiring Systems, Ltd., Yokkaichi-City, Mie, 510-8503 (JP)
(72) Inventor: Aoyama, Masahiko, Yokkaichi-city, Mie 510-8503 (JP)
(74) Representative: Müller-Boré & Partner Patentanwälte

(56) References cited:
- EP-A- 0 926 764
- DE-A- 19 904 277
- GB-A- 1 268 770
- US-A- 3 496 520

## Description

The present invention relates to a method and to a terminal connection apparatus for connecting a flat conductor by a terminal fitting.

Flexible flat cables (FFCs) and flexible printed circuit boards (FPCs) are, for example, known as flat conductors. The FFC is constructed by arraying a plurality of conductive paths parallel to each other and adhering insulation sheets to the front and rear surfaces of the conductive paths so as to have a ribbon-shape and a flexibility as a whole. There are two methods for connecting terminal fittings with the respective conductive paths at an end portion of such an FFC: a method for connecting the terminal fittings while the conductive paths are left imbedded in the insulation sheets and a method for connecting them with the conductive paths exposed at one surface by stripping the insulation sheet at the end.

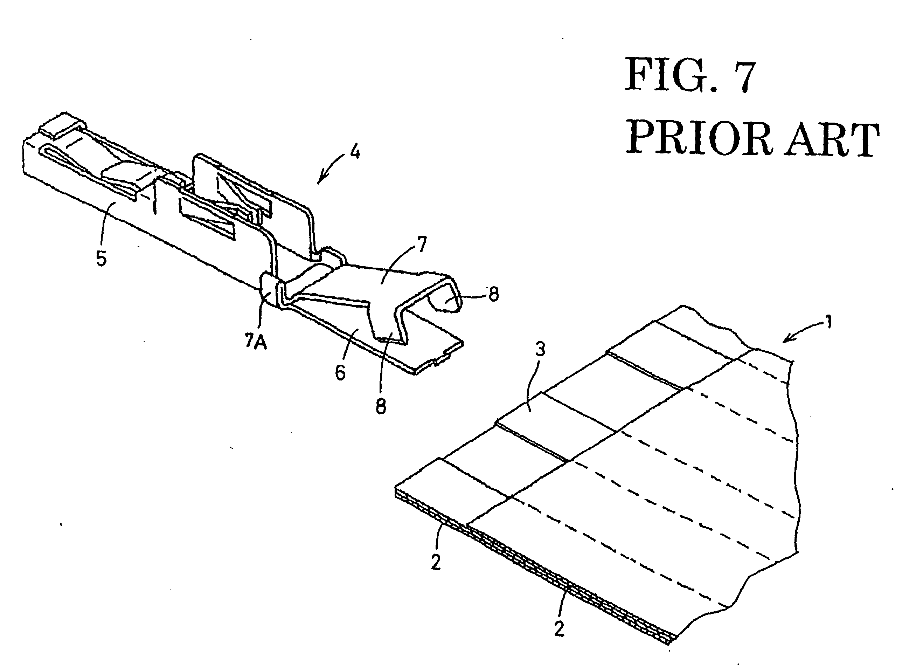

An example of the latter method is disclosed in Japanese Utility Model Publication No. 63-73862. As shown in FIG. 7, an insulation sheet 2 on the front side is stripped by a specified distance at an end of a FFC 1 to expose conductive paths 3 at the front side. On the other hand, a terminal fitting 4 is formed such that a first squeezing plate 6 extends from the rear end of a connecting portion 5 to be connected with a mating terminal fitting (not shown), a base end 7A of a second squeezing plate 7 is integrally formed at the base end of the first squeezing plate 6, and the second squeezing plate 7 is pivotal about the base end 7A so as to close and open with respect to the first squeezing plate 6. Further, crimping pieces 8 extending toward the first squeezing plate 6 are formed at the opposite edges of the leading end of the second squeezing plate 7. When the terminal fitting 4 and the FFC1 are connected, the conductive path 3 is squeezed between the squeezing plates 6 and 7.

However, since the flat second squeezing plate 7 is brought into surface contact with the conductive path 3 by the above method, a contact pressure is inevitably low, causing lack of reliability in electrical contact.

EP-A-0 926 764 discloses a method for connecting a flat conductor and a terminal fitting in which two squeezing plates are deformed such that an exposed portion of the flat conductor may be squeezed therebetween. In order to improve the contact pressure between the squeezing plates and the flat conductor, the squeezing plates are provided with protruding ribs. However, the protruding ribs require an additional step, since they have to be formed in advance.

US-A-3 496 520 discloses a method of connecting a terminal fitting and a flat conductor in which in a first step the flat connector (12) is squeezed between a pair of squeezing plates (22, 24) and in a second step the pair of squeezing plates (22, 24) is deformed into a zigzag configuration.

The present invention was developed in view of the above problem, and an object thereof is to provide a method and apparatus for connecting a terminal fitting and a flat conductor which secure a high contact pressure between the terminal fitting and a conductive path.

This object is solved according to the invention by a method according to claim 1, and an apparatus according to claim 3. Preferred embodiments of the invention are subject of the dependent claims.

Accordingly, the squeezing plates are deformed into a zigzag configuration while the end portion of the flat conductor is being squeezed by the squeezing plates. Thus, the terminal fitting and the flat conductor can be connected with a high contact pressure.

Preferably, the zigzag configuration is formed such that its ridges extend in a direction at an angle different from 0° or 180°, preferably substantially normal to an extension direction of the flat conductor.

Thus, the zigzag configuration is formed such that its ridges preferably extend in a direction normal to the extension of the flat conductor.

Thus, as compared to a case where the zigzag configuration is so formed that their ridges extend parallel to the extension of the flat conductor, a resistance force against a force acting in such a direction to withdraw the flat conductor from the terminal fitting can be increased.

According to a preferred embodiment of the invention, the deformation means comprises two or more press dies having formed recessed and projected portions thereon for forming the zigzag configuration.

The deformation means deforms the squeezing plates into the zigzag configuration while the exposed end portion of the flat conductor is being squeezed by the squeezing plates.

These and other objects, features and advantages of the present invention will become apparent upon reading of the following detailed description of preferred embodiments and accompanying drawings in which:
FIG. 1 is a perspective view showing a state before a terminal fitting and a FFC are connected according to one embodiment of the invention,
FIG. 2 is a development of the terminal fitting,
FIG. 3 is a side view partly in section showing a state before the terminal fitting and the FFC are connected,
FIG. 4 is a side view partly in section showing a state before the terminal fitting is pressed by press dies,
FIG. 5 is a side view partly in section showing a state after the terminal fitting and the FFC are connected,
FIG. 6 is a perspective view after the terminal fitting and the FFC are connected, and
FIG. 7 is a perspective view showing a state before a terminal fitting and a FFC are connected according to a prior art method.

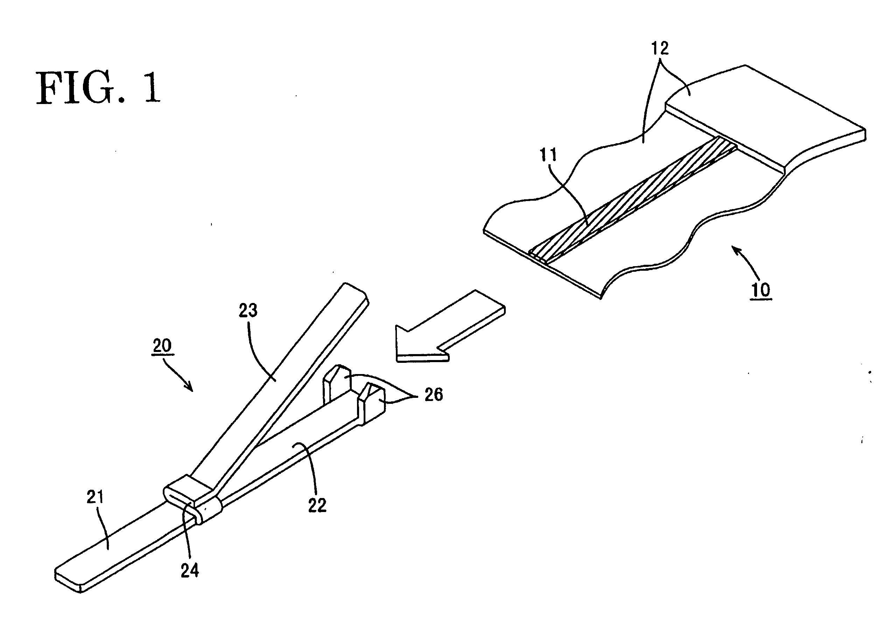

Next, one preferred embodiment of the present invention is described in detail with reference to FIGS. 1 to 6.

FIG. 1 shows a state before a terminal fitting 20 and a substantially flexible flat cable 10 (corresponding to a flat conductor according to a preferred embodiment of the present invention, and hereinafter referred to as "FFC") are connected with each other. The FFC 10 is constructed by substantially arraying or positioning a plurality of conductive paths 11 at least partly substantially parallel to each other (in FIG. 1, only one conductive path 11 and its neighboring portions are shown to simplify the drawing) and adhering insulation sheets 12 preferably to the front and rear surfaces of the conductive paths 11 so as to have a strap- or tape- or ribbon-shape and a flexibility as a whole. The insulation sheet 12 on the front side is stripped in a specified range of an end portion of the FFC 1, so that the respective conductive paths 11 are exposed substantially side by side at the front side or portion.

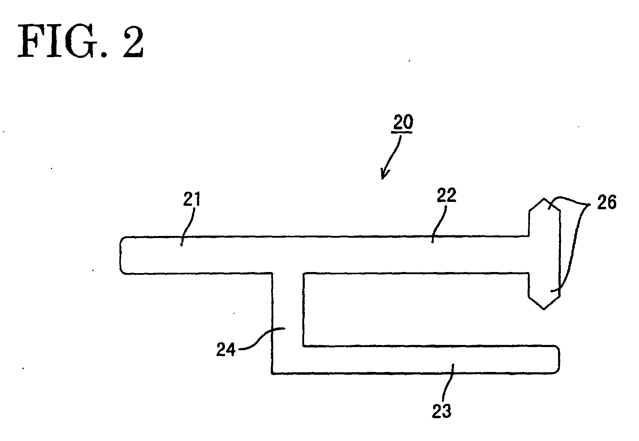

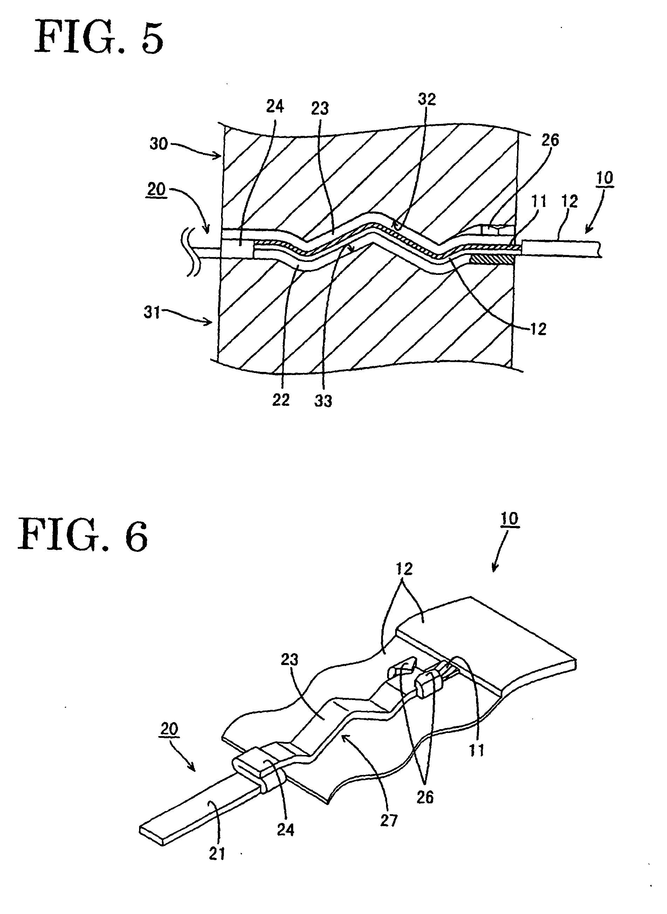

The terminal fitting 20 is preferably a male terminal fitting and is formed e.g. by processing a conductive metallic plate material by a press. This terminal fitting 20 is constructed such that a first connection or squeezing plate 22 extends or projects from the rear end of a tab 21 to be fitted into and connected with a mating female terminal fitting (not shown) and a second connection or squeezing plate 23 is so provided as to substantially face or at least partly correspond to the first squeezing plate 22. In the development of the terminal fitting 20, the second squeezing plate 23 preferably is substantially parallel to the first squeezing plate 22 via a bent portion 24 projecting sideways from the base end of the tab 21 as shown in FIG. 2. During press-forming, the second and first squeezing plates 23, 22 are substantially opposed to each other and the rear (right side in FIG. 2) ends thereof are movable towards each other or to open and close with respect to each other preferably by folding the bent portion 24 back twice (refer to FIGS. 1 and 6).

A length of a portion of the terminal fitting 20 where the first and second squeezing plates 22, 23 are so opposed to open and close with respect to each other preferably substantially equals to the length of the exposed portions of the conductive paths 11 of the FFC 10. The width of the first and second squeezing plates 22, 23 are set slightly wider than that of the conductive paths 11. Further, one or more crimping pieces 26 (corresponding to "holding portion") extending toward the second squeezing plate 23 are formed at the opposite edges of the rear end of the first squeezing plate 22. The upper ends of the respective crimping pieces 26 are formed into such sharp edges that can make cuts in the FFC 10. Preferably, two crimping portions or pieces 26 are arranged at lateral opposite sides of the first squeezing plate 22 and are spaced by a distance substantially greater than the width of the corresponding exposed portion of the conductive path 11. The two crimping pieces 26 may be displaced with respect to each other along the longitudinal direction of the terminal fitting 10 or the first squeezing plate 22.

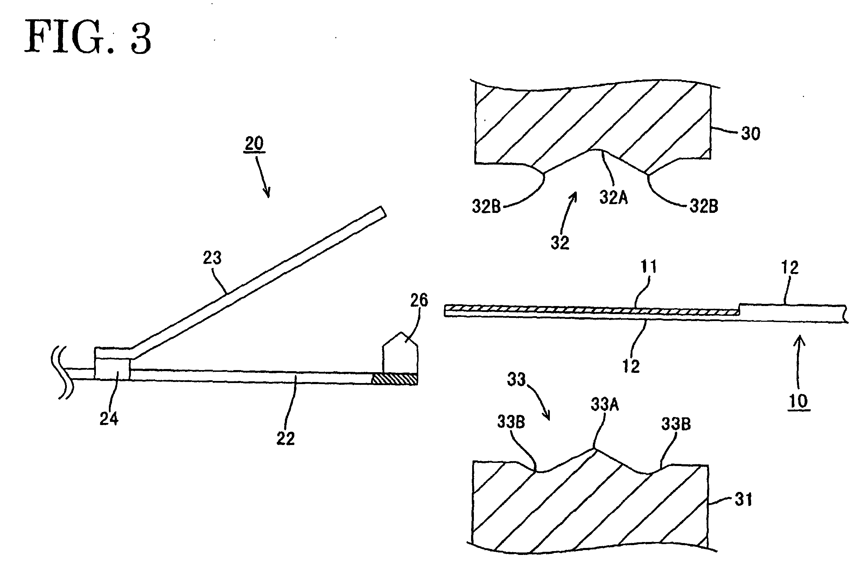

Next, a method for connecting the terminal fitting 20 and the FFC 10 thus constructed is described with reference to FIGS. 3 to 6.

As shown in FIG. 3, the squeezing plates 22, 23 of the terminal fitting 20 are left open, and an end portion of the FFC 10 where the conductive path 11 is exposed is inserted therebetween.

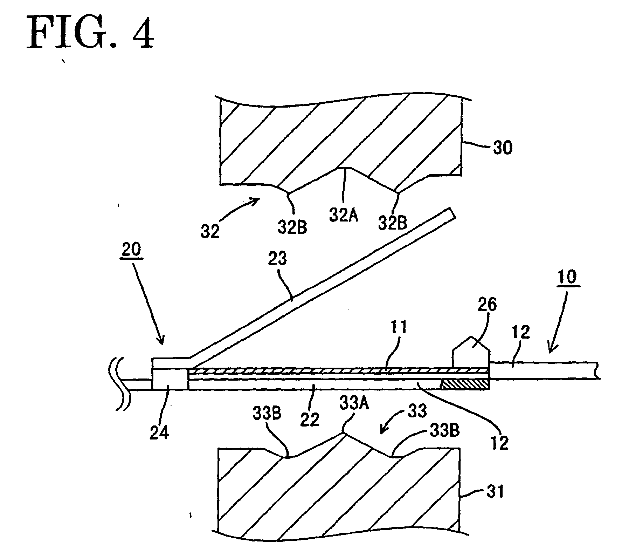

Next, as shown in FIGS. 4 and 5, the terminal fitting 20 is pressed by press dies 30, 31 from above and below the squeezing plates 22, 23. Recessed/projected portions 32, 33 are provided on the outer surfaces of the upper and lower press dies 30, 31. The recessed/projected portion 32 includes a large recess 32A in the middle and two small projections 32B before and after the large recess 32A. The recessed/projected portion 33 includes a large projection 33A in the middle and two small recesses 33B before and after the large projection 33A. The recessed/projected portions 32, 33 are preferably such that their ridges extend in a direction at an angle different from 0° or 180°, preferably substantially perpendicular to the longitudinal direction of the terminal fitting 20 (i.e. preferably substantially parallel to the widthwise direction of the terminal fitting 20). Thus, when the terminal fitting 20 and the FFC 10 are connected, the squeezing plates 22, 23 are formed into a zigzag configuration whose ridges extend in a direction normal to the extension of the FFC 10. It should be noted that the two recessed/projected portions 32, 33 are substantially complementary to each other so as to avoid a displacement when the terminal fitting 20 is pressed. The zigzag configuration 27 is preferably arranged at least partly in a direction normal to the plane containing the portion of the exposed conductor 11 to be connected by or with the terminal fitting 20. In other words, the zigzag configuration 27 extends at least partly out of the plane containing the portion of the exposed conductor 11 so that as a result of the interaction with the terminal fitting 20 the flat conductor 10 is at least partly following the zigzag configuration 27 e.g. in a wavy configuration. The zigzag configuration 27 may be formed with more or less sharp bending portions or ridges, wherein rounded ridges may also be possible. In the latter case, the recesses 32A and 33B as well as the projections 33A and 32B may be formed accordingly.

When the terminal fitting 20 and the FFC 10 are pressed by the pair of press dies 30, 31 constructed as above, the two crimping pieces 26 formed on the first squeezing plate 22 penetrate through the insulation sheet 12 at the substantially opposite sides of the conductive path 11 to reach the front side, and the front and rear surfaces of the end portion of the FFC 10 are tightly held by the first and second squeezing plates 22, 23. During this pressing operation, the squeezing plates 22, 23 of the terminal fitting 20 are deformed or bent (in addition to the deformation of the bent portion 24 caused for substantially joining the two squeezing plates 22, 23) by the recessed/projected portions 32, 33 while squeezing the conductive path 11, with the result that the squeezing plates 22, 23 are deformed into the zigzag configuration 27. Further, during the pressing operation, the crimping pieces 26 are bent inwardly and crimped into connection with the opposite side edges at the rear end of the second squeezing plate 23, with the result that the first and second squeezing plates 22, 23 are connected in their closed state with the exposed portion of the conductive path 11 substantially squeezed or sandwiched or at least partly arranged therebetween.

As described above, according to this embodiment, the conductive path 11 exposed at the end portion of the FFC 10 is squeezed by the squeezing plates 22, 23 while the squeezing plates 22, 23 are being deformed into the zigzag configuration 27. Thus, the terminal fitting 20 and the FFC 10 are connected with a high contact pressure, thereby securing a stable electrical performance.

The FFC 10 as above is used with the terminal fittings 20 connected with its end accommodated in cavities of a connector housing (not shown). In this state, a backward (direction of an arrow F in FIG. 5) acting pulling force may be exerted on the FFC 10. In this embodiment, the zigzag configuration 27 is so formed that their ridges preferably extend in the direction normal to the extension of the FFC 10. Thus, as compared to a case where, for example, the zigzag configuration is so formed that their ridges extend substantially parallel to the extension of the FFC 10, a resistance force against a force acting in the direction to withdraw the FFC 10 from the terminal fitting 20 can be increased.

The present invention is not limited to the above embodiment. For example, following embodiments are also embraced by the technical scope of the present invention as defined by the claims. Further, the technical scope of the present invention is extended to the scope of equivalents as defined by the claims.
(1) Although only one insulation sheet 12 is stripped in the foregoing embodiment, both insulation sheets 12 may be stripped according to the present invention.
(2) Although the terminal fitting 20 is a male terminal fitting in the foregoing embodiment, the present invention may be applied to a female terminal fitting.
(3) Although the FFC 10 is used in the foregoing embodiment, the flat conductor is not limited to the FFC according to the present invention. A flexible printed circuit board or the like may be used.
(4) Although a pair of crimping pieces 26 are formed at the opposite sides of the first squeezing plate 22 in the foregoing embodiment, the holding portions need not be provided at the opposite sides according to the present invention. It may be sufficient to provide at least one holding portion. Further, the holding portion is not limited to the crimping piece 26, but any holding portion may be adopted provided that it can hold a squeezed state of the flat conductor by the two squeezing plates. For example, the holding portion may be a hook projecting from one squeezing plate toward the other.

### LIST OF REFERENCE NUMERALS

- 10: FFC (flat conductor)
- 11: conductive path
- 20: terminal fitting
- 22: first squeezing plate (squeezing plate)
- 23: second squeezing plate (squeezing plate)
- 26: crimping piece (holding portion)
- 27: zigzag configuration

## Claims

1. A method for connecting a flexible flat cable (10) and a terminal fitting (20), comprising the steps of:
at least partly exposing a conductive path (11) at an end portion of the flexible flat cable (10),
arranging at least one pair of squeezing plates (22, 23) of the terminal fitting (20) to at least partly oppose to each other at the front and rear sides of the exposed conductive path (11),
**characterized by**
deforming said squeezing plates (22, 23) into a zigzag configuration (27) during which the exposed end portion of the flat conductor (11) is being squeezed by the squeezing plates (22, 23), and
arranging on one of the squeezing plates (22, 23) two crimping pieces (26) having sharp edges that can make cuts in a flexible flat cable such that said crimping pieces (26) penetrate through an insulation sheet (12) of the flexible flat cable, and
bending the crimping pieces (26) inwardly and crimping into connection with the other of the squeezing plates (22, 23) during the deformation step.

2. A method according to one or more of the preceding claims, wherein the zigzag configuration (27) is formed such that its ridges extend in a direction at an angle different from 0° or 180°, preferably substantially normal to an extension direction of the flexible flat cable (10).

3. A terminal connection apparatus for connecting a flexible flat cable (10) and a terminal fitting (20), comprising:
arranging means for arranging at least one pair of squeezing plates (22, 23) of the terminal fitting (20) to at least partly oppose to each other at the front and rear sides of an exposed conductive path (11)) at an end portion of the flexible flat cable (10), and
deformation means (30, 31) for deforming a portion of the squeezing plates (22, 23) and for squeezing the exposed end portion of the flat conductor (11) by the squeezing plates (22, 23),
**characterized in that**
said deformation means (30, 31) deforms said squeezing plates (22, 23) into a zig-zag configuration (27) by projections (32B, 33A) and recesses (32A, 33B) arranged on said deformation means (30, 31), and
said deformation means (30, 31) displaces two crimping pieces (26) arranged on one of said squeezing plates (22, 23) such that said crimping pieces (26) penetrate through an insulation sheet (12) of the flexible flat cable and such that said crimping pieces (26) are bended inwardly and crimped into connection with the other of the squeezing plates (22, 23)..

## Patentansprüche

1. Verfahren zum Verbinden eines flexiblen flachen Kabels (10) und eines Anschlußkontakts bzw. Anschlußpaßstücks (20), umfassend die Schritte eines:
wenigstens teilweisen Freilegens eines leitfähigen Pfads bzw. Wegs (11) an einem Endabschnitt des flexiblen flachen Kabels (10),
Anordnens wenigstens eines Paars von klemmenden Platten (22, 23) des Anschlußkontakts (20), um wenigstens teilweise einander an den vorderen und rückwärtigen Seiten des freigelegten leitfähigen Pfads (11) gegenüberzuliegen,
**gekennzeichnet durch** ein
Deformieren der klemmenden Platten (22, 23) in eine Zickzack-Konfiguration (27), während welchem der freigelegte Endabschnitt des flachen Leiters (11) **durch** die klemmenden Platten (22, 23) geklemmt wird, und
Anordnen an einer der klemmenden Platten (22, 23) von zwei crimpenden bzw. Crimpstücken (26), welche scharfe Ränder bzw. Kanten aufweisen, welche Schnitte in ein flexibles flaches Kabel derart herstellen können, daß die crimpenden Stücke (26) **durch** ein Isolationsblatt bzw. -schicht (12) des flexiblen flachen Kabels hindurchtreten, und
Biegen der crimpenden Stücke (26) nach innen und Crimpen in Verbindung mit der anderen der klemmenden Platten (22, 23) während des Deformations- bzw. Verformungsschritts.

2. Verfahren nach einem oder mehreren der vorangehenden Ansprüche, wobei die Zickzack-Konfiguration (27) derart ausgebildet wird, daß sich ihre Grate bzw. Rippen in einer Richtung unter einem von 0° oder 180° verschiedenen Winkel, vorzugsweise im wesentlichen normal auf eine Erstreckungsrichtung des flexiblen flachen Kabels (10) erstrecken.

3. Anschlußverbinderapparat zum Verbinden eines flexiblen flachen Kabels (10) und eines Anschlußkontakts bzw. Anschlußpaßstücks (20), umfassend:
Anordnungsmittel zum Anordnen von wenigstens einem Paar von klemmenden Platten (22, 23) des Anschlußkontakts (20), um wenigstens teilweise einander an den vorderen und rückwärtigen Seiten eines freigelegten leitfähigen Pfads bzw. Wegs (11) an einem Endabschnitt des flexiblen flachen Kabels (10) gegenüberzuliegen, und
Deformations- bzw. Verformungsmittel (30, 31) zum Deformieren eines Abschnitts der klemmenden Platten (22, 23) und zum Klemmen des freigelegten Endabschnitts des flachen Leiters (11) durch die klemmenden Platten (22, 23),
**dadurch gekennzeichnet, daß**
die Deformationsmittel (30, 31) die klemmenden Platten (22, 23) in eine Zickzack-Konfiguration (27) durch Vorsprünge bzw. Erhebungen (32B, 33A) und Vertiefungen bzw. Ausnehmungen (32A, 33B) deformieren, welche an den Deformationsmitteln (30, 31) angeordnet sind, und
die Deformationsmittel (30, 31) zwei crimpende Stücke (26) verschieben bzw. verlagern, welche an einer der klemmenden Platten (22, 23) angeordnet sind, so daß die crimpenden Stücke (26) durch ein Isolationsblatt bzw. -schicht (12) des flexiblen flachen Kabels hindurchtreten und daß die crimpenden Stücke (26) nach innen gebogen und in Verbindung mit der anderen der klemmenden Platten (22, 23) gecrimpt sind.

## Revendications

1. Procédé de connexion d'un câble plat flexible (10) et d'une armature de borne (20), comprenant les étapes de
exposition au moins partielle d'un chemin conducteur (11) à une partie d'extrémité du câble plat flexible (10),
agencement d'au moins une paire de plaques de serrage (22, 23) de l'armature de borne (20) en opposition mutuelle au moins partielle sur les côtés avant et arrière du chemin conducteur exposé (11),
**caractérisé par**
la déformation des dites plaques de serrage (22, 23) en une configuration en zigzag (27), pendant laquelle la partie d'extrémité exposée du conducteur plat (11) est comprimée par les plaques de serrage (22, 23),
l'agencement, sur une des plaques de serrage (22, 23), de deux pièces de sertissage (26) ayant des bords vifs qui peuvent effectuer des coupes dans un câble plat flexible de sorte que les dites pièces de sertissage (26) pénètrent à travers une feuille isolante (12) du câble plat flexible, et
le pliage des pièces de sertissage (26) vers l'intérieur, et le sertissage en connexion mutuelle des plaques de serrage (22, 23) pendant l'étape de déformation.

2. Procédé selon une ou plusieurs des revendications précédentes, dans lequel la configuration en zigzag (27) est formée de sorte que ses crêtes s'étendent dans une direction suivant un angle différent de 0° ou 180°, et de préférence sensiblement à angle droit par rapport à une direction d'extension du câble plat flexible (10).

3. Appareil de connexion de borne pour connecter un câble plat flexible (10) et une armature de borne (20), comprenant :
des moyens d'agencement pour agencer au moins deux plaques de serrage (22, 23) de l'armature de borne (20) en opposition mutuelle au moins partielle sur les côtés avant et arrière d'un chemin conducteur découvert (11), à l'endroit d'une partie d'extrémité du câble plat flexible (10), et
des moyens de déformation (30, 31) pour déformer une partie des plaques de serrage (22, 23) et pour serrer la partie d'extrémité découverte du conducteur plat (11) au moyen des plaques de serrage (22, 23),
**caractérisé en ce que**
les dits moyens de déformation (30, 31) déforment les dites plaques de serrage (22, 23) en une configuration en zigzag (27) au moyen de saillies (32B ; 33A) et de creux (32A, 33B) prévus sur les dits moyens de déformation (30, 31), et
les dits moyens de déformation (30, 31) déplacent deux pièces de sertissage (26) prévues sur une des dites plaques de serrage (22, 23) de sorte que les dites pièces de sertissage (26) traversent une feuille isolante (12) du câble plat flexible et de sorte que les dites pièces de sertissage (26) sont pliées vers l'intérieur et serties en connexion avec l'autre des plaques de serrage (22, 23).
